# EUROPEAN PATENT APPLICATION

(11) **EP 4 726 965 A1**
(43) Date of publication of application: **15.04.2026**
(21) Application number: 25178744.6
(22) Date of filing: 26.05.2025
(51) Int. Cl.: H02J 13/00, G01R 31/327, G01R 31/34, G01R 33/00, H02J 3/38

(54) **POWER GENERATION SYSTEM AND MEASUREMENT SYSTEM**

(30) Priority: 08.10.2024 JP 2024176317
(71) Applicant: Kabushiki Kaisha Toshiba, Tokyo 105-0023 (JP)
(72) Inventor: AKITA, Koji, Minato-ku, Tokyo, 105-0023 (JP); TSUTSUMI, Yukako, Minato-ku, Tokyo, 105-0023 (JP); SAKAMOTO, Takafumi, Minato-ku, Tokyo, 105-0023 (JP); UNO, Hiroshi, Minato-ku, Tokyo, 105-0023 (JP); SUMI, Masaki, Minato-ku, Tokyo, 105-0023 (JP)
(74) Representative: Hoffmann Eitle

(57) **Abstract**

According to one embodiment, a power generation system includes a power generator, a power converter, a first detection element, a second detection element, and a detector. The power converter is configured to convert a power generated by the power generator. A first distance between the first detection element and the power converter is shorter than a second distance between the first detection element and the power generator. The detector is configured to output an output signal based on a first detection signal obtained from the first detection element and a second detection signal obtained from the second detection element.

## Description

### CROSS-REFERENCE TO RELATED APPLICATIONS

This application is based upon and claims the benefit of priority from Japanese Patent Application No. 2024-176317, filed on October 8, 2024; the entire contents of which are incorporated herein by reference.

### FIELD

Embodiments described herein relate generally to a power generation system and a measurement system.

### BACKGROUND

In a power generation system, for example, appropriate detection of an abnormality encourages appropriate maintenance and makes it easier to achieve stable operation.

### BRIEF DESCRIPTION OF THE DRAWINGS

FIG. 1 is a schematic diagram illustrating a power generation system according to a first embodiment;
FIGS. 2A to 2C are schematic diagrams illustrating the operation of the power generation system according to the first embodiment;
FIGS. 3A to 3C are schematic diagrams illustrating the operation of the power generation system according to the first embodiment;
FIG. 4 is a schematic diagram illustrating a power generation system according to the first embodiment;
FIG. 5 is a schematic diagram illustrating a power generation system according to the first embodiment;
FIG. 6 is a schematic diagram illustrating a power generation system according to the first embodiment;
FIG. 7 is a schematic diagram illustrating a power generation system according to the first embodiment;
FIG. 8 is a schematic diagram illustrating a power generation system according to the first embodiment;
FIG. 9 is a schematic diagram illustrating the power generation system according to the first embodiment;
FIG. 10 is a schematic diagram illustrating a power generation system according to the first embodiment;
FIG. 11 is a schematic diagram illustrating a power generation system according to the first embodiment;
FIGS. 12A to 12C are schematic diagrams illustrating the operation of the power generation system according to the first embodiment; and
FIG. 13 is a schematic diagram illustrating a power generation system according to the first embodiment.

### DETAILED DESCRIPTION

According to one embodiment, a power generation system includes a power generator, a power converter, a first detection element, a second detection element, and a detector. The power converter is configured to convert a power generated by the power generator. A first distance between the first detection element and the power converter is shorter than a second distance between the first detection element and the power generator. The detector is configured to output an output signal based on a signal information including a first detection signal obtained from the first detection element and a second detection signal obtained from the second detection element.

Various embodiments are described below with reference to the accompanying drawings.

In the specification and drawings, components similar to those described previously or illustrated in an antecedent drawing are marked with like reference numerals, and a detailed description is omitted as appropriate.

### (First Embodiment)

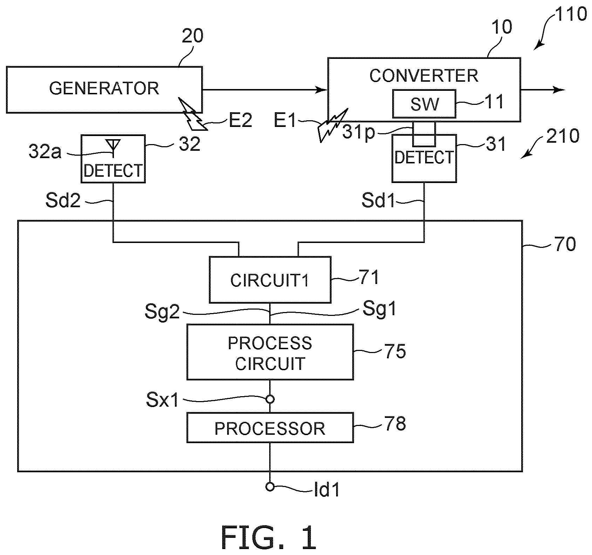

FIG. 1 is a schematic diagram illustrating a power generation system according to the first embodiment.

As shown in FIG. 1, a power generation system 110 according to the embodiment includes a power generator 20, a power converter 10, a first detection element 31, a second detection element 32, and a detector 70.

The power converter 10 is configured to convert the power generated by the power generator 20. The power converter 10 may include, for example, a switching circuit 11. The switching circuit 11 is configured to convert the power generated by the power generator 20. The power converter 10 may correspond to at least a part of a PCS (Power Conditioning System), for example.

The first detection element 31 is provided, for example, near the power converter 10. For example, a distance (first distance) between the first detection element 31 and the power converter 10 is shorter than a distance (second distance) between the first detection element 31 and the power generator 20.

For example, a first detection signal Sd1 is output from the first detection element 31. A second detection signal Sd2 is output from the second detection element 32. These detection signals are supplied to the detector 70.

The detector 70 is configured to output an output signal Sx1 based on a signal information including the first detection signal Sd1 obtained from the first detection element 31 and the second detection signal Sd2 obtained from the second detection element 32. The signal information may consist of the first detection signal Sd1 and the second detection signal Sd2.

For example, the first detection signal Sd1 includes to a first electromagnetic signal E1 from the power converter 10. For example, the second detection signal Sd2 includes to a second electromagnetic signal E2 from the power generator 20 and the first electromagnetic signal E1. For example, the first detection signal Sd1 may correspond to the first electromagnetic signal E1. For example, the second detection signal Sd2 may correspond to the second electromagnetic signal E2. The second detection signal Sd2 is easily influenced by the power converter 10.

The output signal Sx1 is obtained, for example, by processing the first detection signal Sd1 and the second detection signal Sd2. The output signal Sx1 may correspond, for example, to a difference between these signals. In such an output signal Sx1, the mutual influence between the power generator 20 and the power converter 10 is suppressed. For example, by suppressing the influence of the power converter 10, the state of the power generator 20 can be grasped stably with high accuracy. For example, appropriate maintenance is possible. A power generation system capable of stable operation can be provided. The state of the power generator 20 includes, for example, a failure or deterioration.

The processing of the first detection signal Sd1 and the second detection signal Sd2 may include, for example, a comparison process. For example, the difference between the first detection signal Sd1 and the second detection signal Sd2 is detected. For example, the output signal Sx1 may correspond to the difference between the first detection signal Sd1 and the second detection signal Sd2. In such an output signal Sx1, the mutual influence of the power generator 20 and the power converter 10 is suppressed. An example of the processing will be described later.

In a first reference example, the first detection element 31 is provided near the power converter 10, and the second detection element 32 is provided near the power generator 20. In the first reference example, the state of the power converter 10 or the power generator 20 is detected and judged or diagnosed by the first detection signal Sd1 obtained from the first detection element 31, or the second detection signal Sd2 obtained from the second detection element 32. In the first reference example, mutual influence is likely to become noise. In the first reference example, the accuracy of detection of the state of the power converter 10 or the power generator 20 is likely to be reduced due to the influence of noise. It is difficult to obtain an accurate judgment result (diagnosis result).

As described above, in the embodiment, the output signal Sx1 is output based on both the first detection signal Sd1 and the second detection signal Sd2. This suppresses mutual influence. For example, noise is suppressed. The state of at least one of the power converter 10 or the power generator 20 can be detected with high accuracy. Accurate judgment results (diagnosis results) are easily obtained.

As in the example of FIG. 1, the second detection element 32 may be provided near the power generator 20. For example, a distance (third distance) between the second detection element 32 and the power generator 20 is shorter than a distance (fourth distance) between the second detection element 32 and the power converter 10. By providing the second detection element 32 near the power generator 20, the influence from the power converter 10 can be further suppressed.

In the embodiment, the state of the power converter 10 may be detected by the output signal Sx1 based on the first detection signal Sd1 and the second detection signal Sd2. For example, the influence of the power generator 20 can be suppressed, and the state of the power converter 10 can be grasped stably with high accuracy.

As shown in FIG. 1, in this example, the detector 70 includes a first circuit 71 and a processing circuit 75. The first circuit 71 is configured to generate a first signal Sg1 obtained by processing the first detection signal Sd1, and a second signal Sg2 obtained by processing the second detection signal Sd2. The processing circuit 75 is configured to process the first signal Sg1 and the second signal Sg2 to generate the output signal Sx1.

For example, the first detection signal Sd1 is AD converted to obtain the first signal Sg1. For example, the second detection signal Sd2 is AD converted to obtain the second signal Sg2. The intensity of the first detection signal Sd1 may be adjusted to obtain the first signal Sg1. The intensity of the second detection signal Sd2 may be adjusted to obtain the second signal Sg2. By the first signal Sg1 and the second signal Sg2, the signal processing becomes simple. Thus, the processing in the first circuit 71 may include at least one of the AD conversion or the amplitude adjustment.

For example, the detector 70 may be configured to process the first signal Sg1 based on the first detection signal Sd1 and the second signal Sg2 based on the second detection signal Sd2 by a first process to derive the output signal Sx1. The first process may include at least one of a comparison process or a cancellation process.

The comparison process includes deriving a result of comparing the first signal Sg1 and the second signal Sg2. For example, the comparison process may include deriving a difference between the first signal Sg1 and the second signal Sg2. For example, the output signal Sx1 may include the result of the comparison. For example, the output signal Sx1 may correspond to the difference between the first signal Sg1 and the second signal Sg2.

The cancellation process includes removing at least a part of the second signal component included in the second signal Sg2 using at least a part of the first signal Sg1. For example, the output signal Sx1 may include the signal component after the removal. The cancellation process may include removing at least a part of the component included in the first signal Sg1 using at least a part of the second signal Sg2.

The first process may include the following correlation process. The correlation process includes deriving a component of at least one of the first signal Sg1 or the second signal Sg2. In the correlation process, a correlation value between the first signal Sg1 and the second signal Sg2 is less than a threshold value for at least a part of the component. By detecting components with small correlation values, the state of at least one of the power generator 20 or the power converter 10 can be detected with high accuracy.

As described above, the output signal Sx1 may correspond to the state (first state) of the power generator 20. The first state includes at least one of a failure of the power generator 20 or deterioration of the power generator 20.

As shown in FIG. 1, the detector 70 may include a processor 78. The processor 78 may be configured to output information Id1 relating to the above-mentioned first state based on the output signal Sx1. The information Id1 may include, for example, a notification or an alert. The processor 78 may determine, for example, a failure or deterioration of the power generator 20. The information Id1 may include a determination result relating to the failure or deterioration. In the embodiment, a device included in the power generation system 110 (for example, the power generator 20) may be automatically controlled or adjusted based on at least one of the output signal Sx1 or the information Id1. The control may include, for example, stopping operation. The adjustment may include, for example, a reduction in the amount of power generation.

As shown in FIG. 1, the first detection element 31 may include a probe 31p. The probe 31p may be in contact with the power converter 10. In this case, the probe 31p acquires electromagnetic signals from the power converter 10 by conduction. Alternatively, the probe 31p may not be in contact with the power converter 10.

The second detection element 32 may include an antenna 32a. The antenna 32a acquires electromagnetic signals propagating in a space around the antenna 32a. The electromagnetic signals include, for example, the first electromagnetic signal E1 from the power converter 10 and the second electromagnetic signal E2 from the power generator 20. By the antenna 32a, these electromagnetic signals can be detected with high accuracy and high efficiency.

In a case where the power converter 10 includes the switching circuit 11, a high-intensity electromagnetic signal (first electromagnetic signal E1) is likely to be generated from the switching circuit 11 in power conversion. The high-intensity electromagnetic signal from the switching circuit 11 becomes noise in detecting the state of the power generator 20. In the embodiment, even in a case where the power converter 10 includes the switching circuit 11, the effects of noise can be suppressed and the state of the power generator 20 can be detected with high sensitivity and high accuracy.

In the case where the power converter 10 includes the switching circuit 11, the control signal of the switching circuit 11 may be used as the first detection signal Sd1. In one example, a first signal Sg1 may be generated from the control signal of the switching circuit 11. The output signal Sx1 may be derived according to the difference between such a first signal Sg1 and the second signal Sg2. In this case as well, the effects of noise can be suppressed and the state of the power generator 20 can be detected with high sensitivity and high accuracy. Appropriate maintenance is encouraged. A power generation system capable of stable operation can be provided. Another example of control in which the control signal of the switching circuit 11 is used will be described later.

In the embodiment, the output signal Sx1 may correspond to a state (second state) of the power converter 10. The second state includes at least one of a failure of the power converter 10 or degradation of the power converter 10. The processor 78 may be configured to the output information Id1 relating to the second state based on the output signal Sx1. The processor 78 may determine, for example, a failure or degradation of the power converter 10. The information Id1 may include a determination result relating to the failure or degradation.

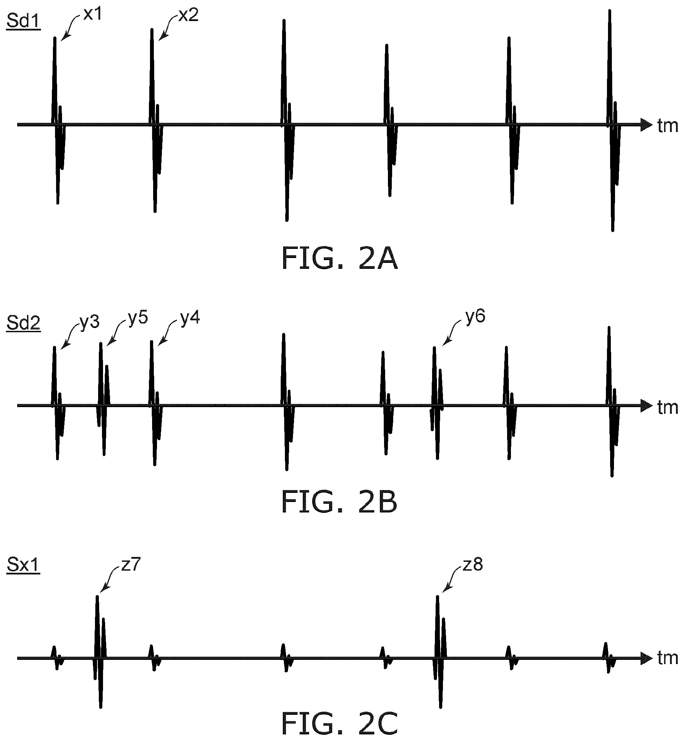

FIGS. 2A to 2C are schematic diagrams illustrating the operation of the power generation system according to the first embodiment.

The horizontal axis of these diagrams is time *tm.* FIG. 2A corresponds to the first detection signal Sd1. FIG. 2B corresponds to the second detection signal Sd2. FIG. 2C corresponds to the output signal Sx1.

As shown in FIG. 2A, the first detection signal Sd1 includes a first component x1 and a second component x2. The first component x1 and the second component x2 are periodic.

As shown in FIG. 2B, the second detection signal Sd2 includes a third component y3, a fourth component y4, a fifth component y5, and a sixth component y6. The third component y3 is synchronized with the first component x1. The fourth component y4 is synchronized with the second component x2. In this example, the first detection signal Sd1 does not substantially include components synchronized with the fifth component y5 and the sixth component y6.

As shown in FIG. 2C, the output signal Sx1 includes a seventh component z7 and an eighth component z8. The seventh component z7 is synchronized with, for example, the fifth component y5. The eighth component z8 is synchronized with, for example, the sixth component y6. Such an output signal Sx1 is obtained, for example, from the difference between the first signal Sg1 based on the first detection signal Sd1 and the second signal Sg2 based on the second detection signal Sd2.

For example, the third component y3 and fourth component y4 included in the second detection signal Sd2 are considered to be influenced by the power converter 10. On the other hand, the fifth component y5 and sixth component y6 included in the second detection signal Sd2 are considered to be substantially unaffected by the power converter 10. The fifth component y5 and sixth component y6 are considered to be characteristics unique to the power generator 20. The seventh component z7 and eighth component z8 are considered to be characteristics unique to the power generator 20.

In the output signal Sx1 based on both the first detection signal Sd1 and the second detection signal Sd2, the influence from the power converter 10 is suppressed, and the seventh component z7 and the eighth component z8 corresponding to the characteristics specific to the power generator 20 are obtained stably with high accuracy.

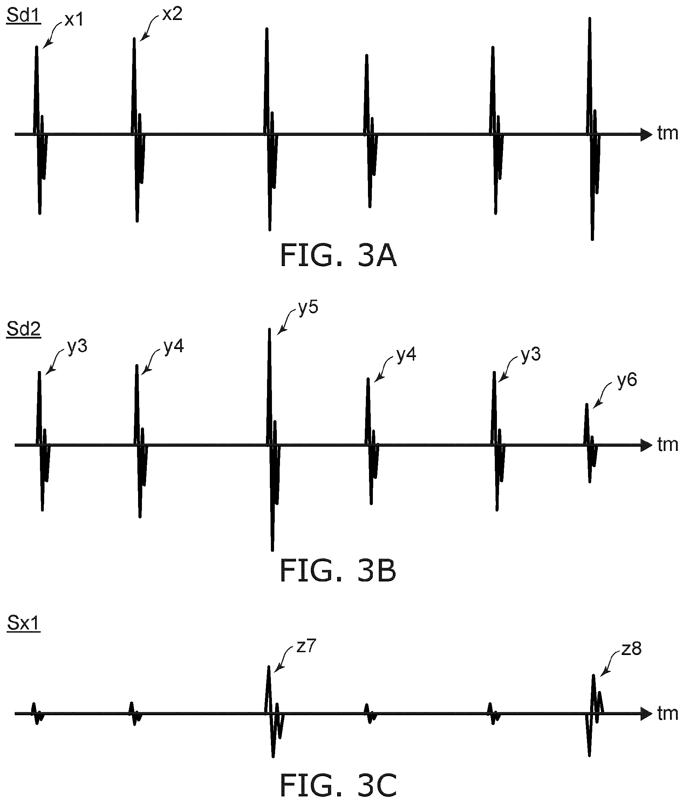

FIGS. 3A to 3C are schematic diagrams illustrating the operation of the power generation system according to the first embodiment.

The horizontal axis of these diagrams is time *tm.* FIG. 3A corresponds to the first detection signal Sd1. FIG. 3B corresponds to the second detection signal Sd2. FIG. 3C corresponds to the output signal Sx1.

As shown in FIG. 3A, the first detection signal Sd1 includes a first component x1 and a second component x2. The first component x1 and the second component x2 are periodic.

As shown in FIG. 3B, the second detection signal Sd2 includes a third component y3, a fourth component y4, a fifth component y5, and a sixth component y6. These components are synchronized with the first component x1 and the second component x2. In this example, the magnitude of the third component y3 is substantially the same as the magnitude of the fourth component y4. The magnitude of the fifth component y5 is greater than the magnitude of the third component y3. The magnitude of the sixth component y6 is less than the magnitude of the fourth component y4.

As shown in FIG. 3C, the output signal Sx1 includes a seventh component z7 and an eighth component z8. The seventh component z7 is synchronized with, for example, the fifth component y5. The eighth component z8 is synchronized with, for example, the sixth component y6. Such an output signal Sx1 is obtained, for example, from the difference between the first detection signal Sd1 and the second detection signal Sd2.

In the example of FIG. 3B, the fifth component y5 is thought to occur in a case where the electromagnetic signal from the power generator 20 and the electromagnetic signal from the power converter 10 constructively interact with each other. The sixth component y6 is thought to occur in a case where the electromagnetic signal from the power generator 20 and the electromagnetic signal from the power converter 10 destructively interact with each other.

In the output signal Sx1 based on both the first detection signal Sd1 and the second detection signal Sd2, for example, the influence from the power converter 10 is suppressed, and the seventh component z7 and the eighth component z8 corresponding to the characteristics specific to the power generator 20 are obtained stably with high accuracy.

In the examples of FIGS.2A to 2C and 3A to 3C, the output signal Sx1 may be obtained by the first processing described above. As already explained, the first processing may include the comparison processing. The first processing may include the cancellation processing. The first processing may include the correlation processing.

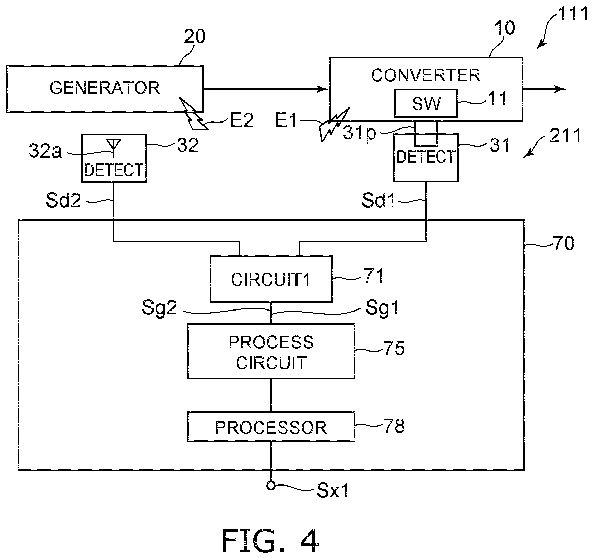

FIG. 4 is a schematic diagram illustrating a power generation system according to the first embodiment.

As shown in FIG. 4, in a power generation system 111 according to the embodiment, the output signal Sx1 is output from the processor 78 of the detector 70. Except for this, the configuration of the power generation system 111 may be the same as the configuration of the power generation system 110.

In the power generation system 111, the output signal Sx1 includes information about the state (first state) of the power generator 20. The information may include a notification or an alert. In the power generation system 111, maintenance is also appropriately encouraged. A power generation system capable of stable operation can be provided.

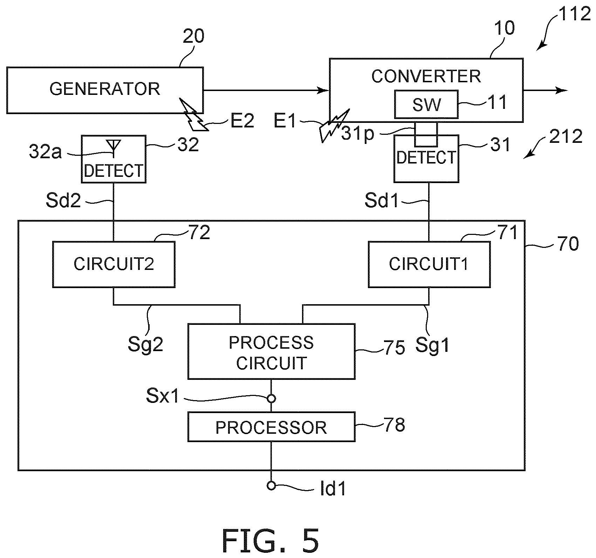

FIG. 5 is a schematic diagram illustrating a power generation system according to the first embodiment.

As shown in FIG. 5, in a power generation system 112 according to the embodiment, the detector 70 includes the first circuit 71, a second circuit 72, and the processing circuit 75. Except for this, the configuration of the power generation system 112 may be the same as the configuration of the power generation system 110.

The first circuit 71 is configured to process the first detection signal Sd1 to generate the first signal Sg1. The second circuit 72 is configured to process the second detection signal Sd2 to generate the second signal Sg2. The processing circuit 75 is configured to process the first signal Sg1 and the second signal Sg2 to generate the output signal Sx1. The processing in the first circuit 71 and the second circuit 72 may include, for example, at least one of AD conversion or amplitude adjustment.

By providing the first circuit 71 and the second circuit 72, the distance between the first circuit 71 and the first detection element 31 can be shortened. The distance between the second circuit 72 and the second detection element 32 can be shortened. Noise can be further suppressed.

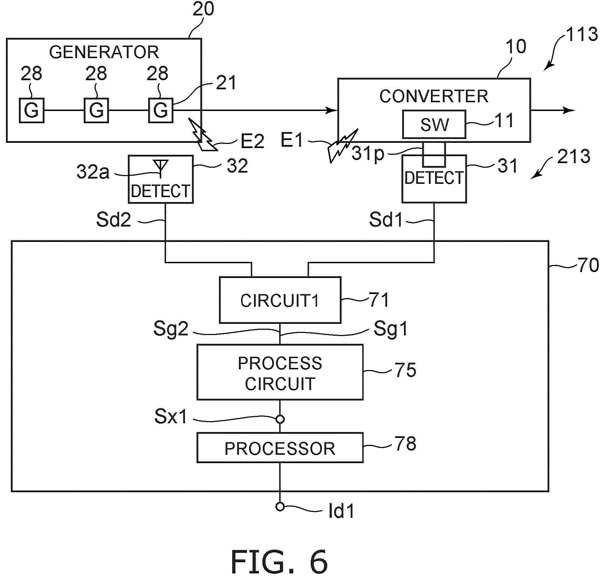

FIG. 6 is a schematic diagram illustrating a power generation system according to the first embodiment.

As shown in FIG. 6, in a power generation system 113 according to the embodiment, the power generator 20 includes a plurality of components 28. Except for this, the configuration of the power generation system 113 may be the same as the configuration of the power generation system 110.

For example, the plurality of components 28 include a first component 21. The first component 21 is the closest to the power converter 10 among the plurality of components 28. In this example, the distance between the second detection element 32 and the first component 21 is shorter than the distance between the second detection element 32 and the other plurality of components 28. The second detection element 32 may be provided near the first component 21 that is closest to the power converter 10.

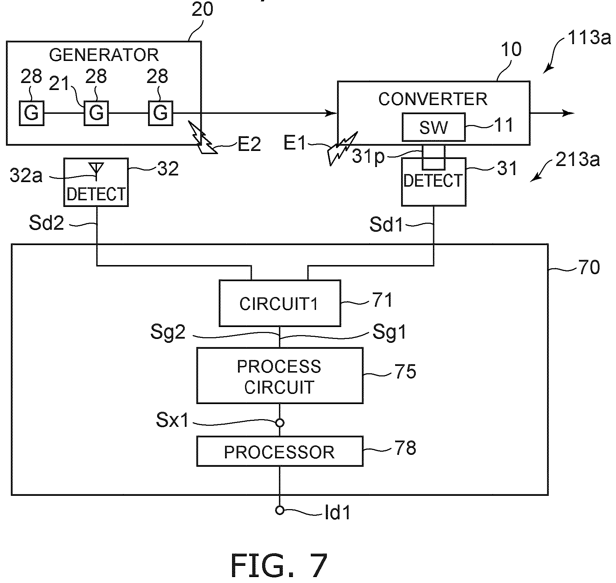

FIG. 7 is a schematic diagram illustrating a power generation system according to the first embodiment.

As shown in FIG. 7, in a power generation system 113a according to the embodiment, the power generator 20 includes the plurality of components 28. Except for this, of the configuration of the power generation system 113a may be the same as the configuration of the power generation system 110.

For example, the plurality of components 28 includes the first component 21. The first component 21 is located at a position including a center of the plurality of components. In this example, the distance between the second detection element 32 and the first component 21 is shorter than the distance between the second detection element 32 and the other plurality of components 28. The second detection element 32 may be provided near the first component 21 at a substantially central position of the plurality of components.

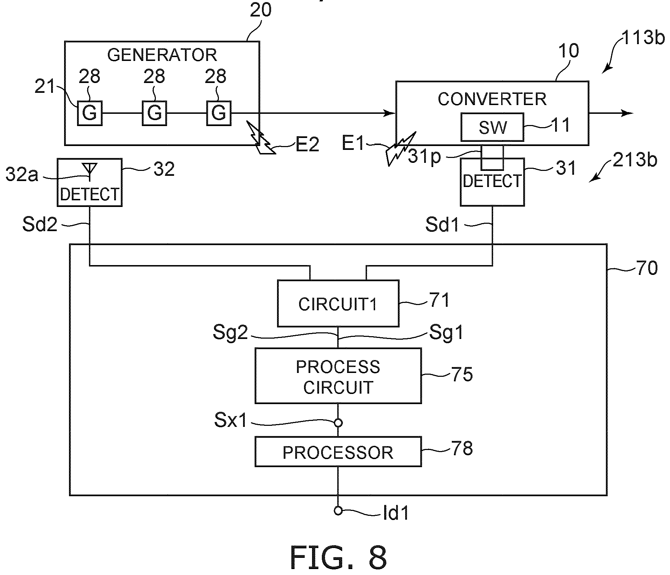

FIG. 8 is a schematic diagram illustrating a power generation system according to the first embodiment.

As shown in FIG. 8, in a power generation system 113b according to the embodiment, the power generator 20 includes the plurality of components 28. Except for this, the configuration of the power generation system 113b may be the same as the configuration of the power generation system 110.

For example, the plurality of components 28 include the first component 21. The first component 21 is the farthest from the power converter 10 among the plurality of components 28. In this example, the distance between the second detection element 32 and the first component 21 is shorter than the distance between the second detection element 32 and the other plurality of components 28. The second detection element 32 may be provided near the first component 21 that is the farthest from the power converter 10.

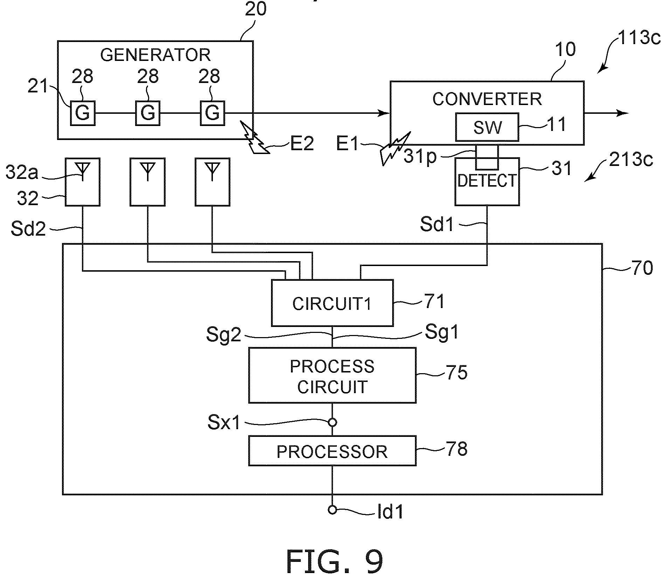

FIG. 9 is a schematic diagram illustrating the power generation system according to the first embodiment.

As shown in FIG. 9, in a power generation system 113c according to the embodiment, a plurality of second detection elements 32 are provided. Except for this, the configuration of the power generation system 113c may be the same as the configuration of the power generation system 110. For example, the plurality of second detection elements 32 may be provided corresponding to the plurality of components 28. The state of each of the plurality of components 28 can be detected with high accuracy.

In the case of thermal power generation, the plurality of components 28 include, for example, a turbine and a generator. In the case of hydroelectric power generation, the plurality of components 28 include, for example, a water wheel and a generator. In the case of wind power generation, the plurality of components 28 include, for example, a blade, a gearbox, and a generator. The above components may be further divided into smaller components. In a case where one of the plurality of components 28 is a blade, the plurality of components 28 may include, for example, a blade portion, a shaft portion, and a bearing portion that receives the shaft portion. The plurality of components 28 may be arranged along one direction, for example.

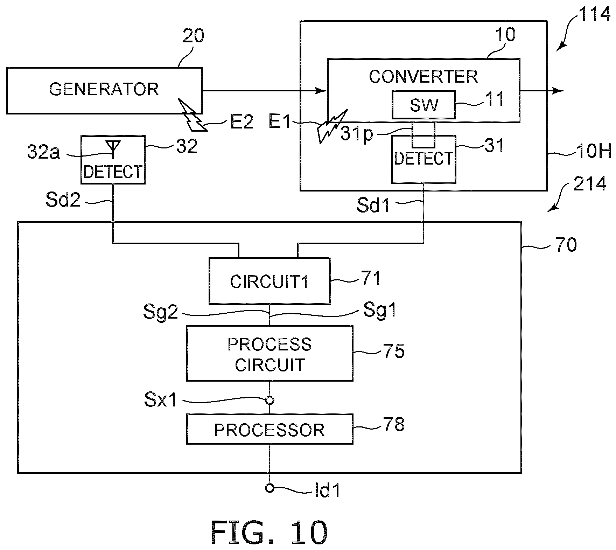

FIG. 10 is a schematic diagram illustrating a power generation system according to the first embodiment.

As shown in FIG. 10, a power generation system 114 according to the embodiment includes a housing 10H. Except for this, the configuration of the power generation system 114 may be the same as the configuration of the power generation system 110.

The power converter 10 and the first detection element 31 are located inside the housing 10H. The housing 10H is, for example, conductive. The housing 10H functions, for example, as an electromagnetic shield. Noise can be further suppressed.

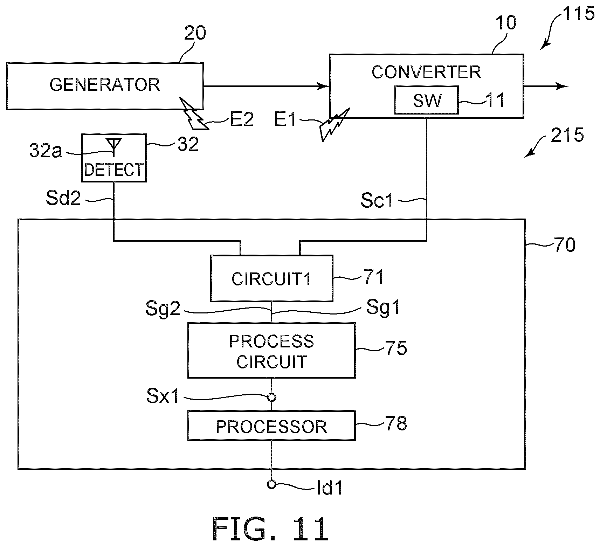

FIG. 11 is a schematic diagram illustrating a power generation system according to the first embodiment.

As shown in FIG. 11, in a power generation system 115 according to the embodiment, the first detection element 31 is omitted. Except for this, the configuration of the power generation system 115 may be the same as the configuration of the power generation system 110.

For example, the power generation system 115 includes the power generator 20, the power converter 10, the second detection element 32, and the detector 70. The power converter 10 includes the switching circuit 11. The switching circuit 11 is configured to convert the power generated by the power generator 20. The detector 70 is configured to output the output signal Sx1 based on a control signal Sc1 of the switching circuit 11 and the second detection signal Sd2 obtained from the second detection element 32.

In a case where the power converter 10 includes the switching circuit 11, the first electromagnetic signal E1 from the power converter 10 is likely to be synchronized with the operation of the switching circuit 11. By referring to the control signal Sc1 for the operation of the switching circuit 11, the influence from the power converter 10 included in the second detection signal Sd2 obtained from the second detection element 32 can be effectively suppressed. The state of the power generator 20 can be detected accurately and stably. For example, appropriate maintenance is encouraged. A power generation system capable of stable operation can be provided.

In one example, the control signal Sc1 may have a first polarity when transitioning from the off state to the on state, and a second polarity when transitioning from the on state to the off state. The first polarity may be one of positive and negative. The second polarity may be the other one of positive and negative. The control signal Sc1 may include a periodically repeating waveform.

For example, the detector 70 may include a plurality of switching circuits 11. The control signal Sc1 may be provided corresponding to each of the plurality of switching circuits 11. One of the plurality of control signals Sc1 may be controlled by one of the plurality of control signals Sc1. Another one of the plurality of switching circuits 11 may be controlled by another one of the plurality of control signals Sc1. The plurality of control signals Sc1 may have the same period. The plurality of control signals Sc1 may have different periods. The plurality of control signals Sc1 may have different phases. The detector 70 may be configured to output the output signal Sx1 based on the plurality of control signals Sc1 and the second detection signal Sd2 obtained from the second detection element 32. The state of the power generator 20 can be detected accurately and stably. For example, appropriate maintenance is encouraged. A power generation system capable of stable operation can be provided. The detector 70 may be configured to output the output signal Sx1 based on a signal obtained by combining the plurality of control signals Sc1 and the second detection signal Sd2 obtained from the second detection element 32.

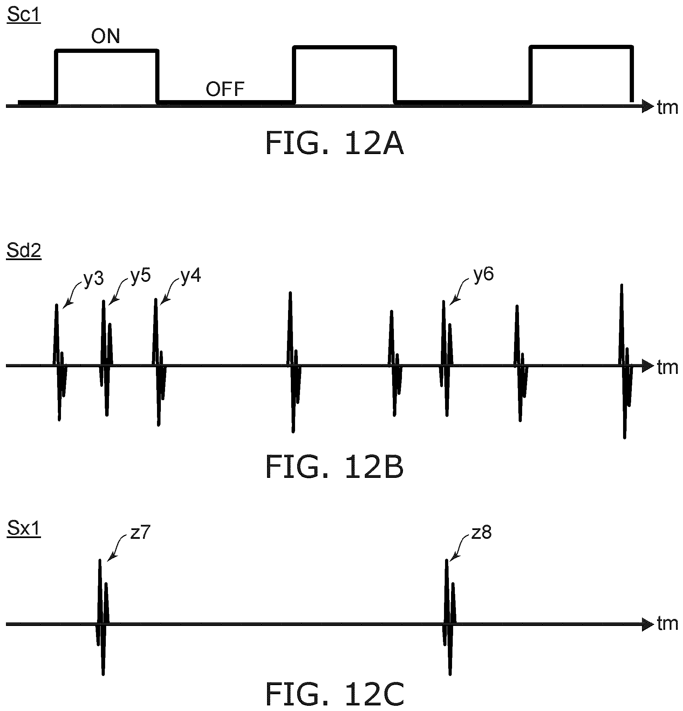

FIGS. 12A to 12C are schematic diagrams illustrating the operation of the power generation system according to the first embodiment.

The horizontal axis of these diagrams is time *tm.* FIG. 12A corresponds to the control signal Sc1 of the switching circuit 11. FIG. 12B corresponds to the second detection signal Sd2. FIG. 12C corresponds to the output signal Sx1.

As shown in FIG. 12A, the control signal repeats ON/OFF. The ON/OFF is cyclic.

As shown in FIG. 12B, the second detection signal Sd2 includes a third component y3, a fourth component y4, a fifth component y5, and a sixth component y6. The third component y3 and the fourth component y4 are synchronized with the ON/OFF of the control signal Sc1. The fifth component y5 and the sixth component y6 are not synchronized with the control signal Sc1.

As shown in FIG. 12C, the output signal Sx1 includes a seventh component z7 and an eighth component z8. The seventh component z7 is synchronized with, for example, the fifth component y5. The eighth component z8 is synchronized with, for example, the sixth component y6. Such an output signal Sx1 is obtained, for example, from the difference between the control signal Sc1 and the second signal Sg2 based on the second detection signal Sd2. For example, the component of the second detection signal Sd2 that corresponds to the switching timing of the control signal Sc1 is substantially excluded.

In the output signal Sx1, which is based on both the control signal Sc1 and the second detection signal Sd2, the influence from the power converter 10 is suppressed, and the state of the power generator 20 can be obtained stably with high accuracy.

The configuration described for power generation system 115 may be applied to the power generation system 111, the power generation system 113a, the power generation system 113b, and the power generation system 113c, etc.

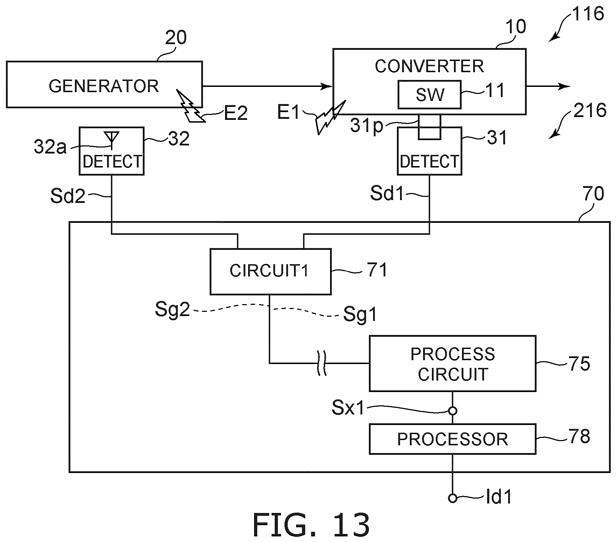

FIG. 13 is a schematic diagram illustrating a power generation system according to the first embodiment.

As shown in FIG. 13, in a power generation system 116 according to the embodiment, the position of at least a part of the detector 70 is different from the positions at which the first detection element 31 and the second detection element 32 are provided. Except for this, the configuration of the power generation system 116 may be the same as the configuration of the power generation system 110.

In the power generation system 116, communication between the first detection element 31 and at least a part of the detector 70, and communication between the second detection element 32 and at least a part of the detector 70 may be performed by at least one of wired or wireless communication. For example, the position where the first circuit 71 is provided and the position where the processing circuit 75 and the processor 78 are provided may be different from each other.

At least a part of the detector 70 may be implemented, for example, as a computer connected via a network. The computer may be a cloud computer.

As described above, the first detection signal Sd1 obtained from the first detection element 31 corresponds to the first electromagnetic signal E1 from the power converter 10. The second detection signal Sd2 obtained from the second detection element 32 may correspond to the second electromagnetic signal E2 and the first electromagnetic signal E1 from the power generator 20. In the embodiment, the first detection element 31 may detect various signals obtained from the power converter 10. The second detection element 32 may detect various signals obtained from the power generator 20. The various signals may include, for example, at least one of vibrations, sound waves, or light.

### (Second Embodiment)

The second embodiment relates to a measurement system. As shown in FIG. 1, a measurement system 210 according to the embodiment includes the first detection element 31, the second detection element 32, and the detector 70. The first distance between the first detection element 31 and the power converter 10 is shorter than the second distance between the first detection element 31 and the power generator 20. The power converter 10 is configured to convert the power generated by the power generator 20. The detector 70 is configured to output the output signal Sx1 based on the first detection signal Sd1 obtained from the first detection element 31 and the second detection signal Sd2 obtained from the second detection element 32. A measurement system capable of stable operation can be provided.

As shown in FIG. 11, the measurement system 215 according to the embodiment includes the second detection element 32 and the detector 70. The second detection element 32 is configured to detect the electromagnetic signal (second electromagnetic signal E2) from the power generator 20. The detector 70 is configured to output the output signal Sx1 based on the control signal Sc1 of the switching circuit 11 configured to convert the power generated by the power generator 20, and the second detection signal Sd2 obtained from the second detection element. A measurement system capable of stable operation can be provided.

The various configurations described for the power generation system 110 can be applied to the measurement system 210. As shown in FIGS 4 to 11 and 13, the configurations described for the power generation system 111, the power generation system 112, the power generation system 113, the power generation system 113a, the power generation system 113b, the power generation system 113c, the power generation system 114, the power generation system 115, and the power generation system 116 can be applied to a measurement system 211, a measurement system 212, a measurement system 213, a measurement system 213a, a measurement system 213b, a measurement system 213c, a measurement system 214, a measurement system 215, and a measurement system 216 according to the embodiment, respectively.

For example, large noise is likely to occur when the switching circuit 11 is provided. In the embodiment, for example, the effects of noise can be suppressed while a failure or deterioration of the power generator 20 can be detected stably with high accuracy. For example, electromagnetic signals caused by failure or deterioration can be effectively detected.

For example, the first detection element 31 efficiently detects the electromagnetic signal generated by the power converter 10. The second detection element 32 can efficiently detect the signal generated by the power generator 20 while suppressing the influence of the electromagnetic signal generated by the power converter 10. For example, the signal generated by the power generator 20 can be detected with high accuracy. The second detection element 32 is capable of detecting a wide range of electromagnetic signals.

The embodiment may include the following Technical proposals:
(Technical proposal 1) A power generation system, comprising:
   a power generator;
   a power converter configured to convert a power generated by the power generator;
   a first detection element, a first distance between the first detection element and the power converter being shorter than a second distance between the first detection element and the power generator;
   a second detection element; and
   a detector configured to output an output signal based on a signal information including a first detection signal obtained from the first detection element and a second detection signal obtained from the second detection element.
(Technical proposal 2) The power generation system according to Technical proposal 1, wherein
   the first detection signal includes to a first electromagnetic signal from the power converter, and
   the second detection signal includes to a second electromagnetic signal from the power generator and the first electromagnetic signal.
(Technical proposal 3) The power generation system according to Technical proposal 1 or 2, wherein
   a third distance between the second detection element and the power generator is shorter than a fourth distance between the second detection element and the power converter.
(Technical proposal 4) The power generation system according to any one of Technical proposals 1-3, wherein
   the output signal includes information regarding a difference between a first signal based on the first detection signal and a second signal based on the second detection signal.
(Technical proposal 5) The power generation system according to any one of Technical proposals 1-3, wherein
   the detector is configured to process a first signal based on the first detection signal and a second signal based on the second detection signal by a first process to derive the output signal,
   the first process includes at least one of a comparison process, a cancellation process, or a correlation process,
   the comparison process includes deriving a result of comparing the first signal and the second signal,
   the cancellation process includes removing at least a part of a second signal component included in the second signal using at least a part of the first signal, and
   the correlation process includes deriving a component of at least one of the first signal and the second signal, and a correlation value between the first signal and the second signal is less than a threshold value for the component.
(Technical proposal 6) The power generation system according to Technical proposal 1, wherein
   the detector includes a first circuit and a processing circuit,
   the first circuit is configured to generate a first signal obtained by processing the first detection signal and a second signal obtained by processing the second detection signal,
   the processing circuit is configured to generate the output signal according to a difference between the first signal and the second signal.
(Technical proposal 7) The power generation system according to Technical proposal 1, wherein
   the detector includes a first circuit, a second circuit, and a processing circuit,
   the first circuit is configured to process the first detection signal to generate a first signal,
   the second circuit is configured to process the second detection signal to generate a second signal, and
   the processing circuit is configured to generate the output signal according to a difference between the first signal and the second signal.
(Technical proposal 8) The power generation system according to any one of Technical proposals 1-7, wherein
   the output signal corresponds to a first state of the power generator, and
   the first state includes at least one of a failure of the power generator or a deterioration of the power generator.
(Technical proposal 9) The power generation system according to Technical proposal 8, wherein
   the detector includes a processor, and
   the processor is configured to output information regarding the first state based on the output signal.
(Technical proposal 10) The power generation system according to Technical proposal 8, wherein
   the output signal includes information regarding the first state.
(Technical proposal 11) The power generation system according to any one of Technical proposals 1-10, wherein
   the power converter includes a switching circuit, and
   the switching circuit is configured to convert the power.
(Technical proposal 12) The power generation system according to any one of Technical proposals 1-11, wherein
   the first detection element includes a probe, and
   the probe is in contact with the power converter or is not in contact with the power converter.
(Technical proposal 13) The power generation system according to any one of Technical proposals 1-12, wherein
   the second detection element includes an antenna.
(Technical proposal 14) The power generation system according to any one of Technical proposals 1-13, wherein
   the power generator includes a plurality of components,
   the plurality of components includes a first component,
   the first component is the closest to the power converter among the plurality of components, and
   a distance between the second detection element and the first component is shorter than a distance between the second detection element and other of the plurality of components.
(Technical proposal 15) The power generation system according to any one of Technical proposals 1-13, wherein
   the power generator includes a plurality of components,
   the plurality of components includes a first component,
   the first component is located at a position including a center of the plurality of components, and
   a distance between the second detection element and the first component is shorter than a distance between the second detection element and other of the plurality of components.
(Technical proposal 16) The power generation system according to any one of Technical proposals 1-13, wherein
   the power generator includes a plurality of components,
   the plurality of components includes a first component,
   the first component is the furthest from the power converter among the plurality of components, and
   a distance between the second detection element and the first component is shorter than a distance between the second detection element and other of the plurality of components.
(Technical proposal 17) The power generation system according to any one of Technical proposals 1-16, further comprising:
   a housing,
   the power converter and the first detection element being in the housing.
(Technical proposal 18) A power generation system, comprising:
   a power generator;
   a power converter including a switching circuit configured to convert a power generated by the power generator;
   a second detection element; and
   a detector configured to output an output signal based on a control signal of the switching circuit and a second detection signal obtained from the second detection element.
(Technical proposal 19) A measurement system, comprising:
   a first detection element, a first distance between the first detection element and a power converter being is shorter than a second distance between the first detection element and a power generator, the power converter being configured to convert a power generated by the power generator;
   a second detection element; and
   a detector configured to output an output signal based on a first detection signal obtained from the first detection element and a second detection signal obtained from the second detection element.
(Technical proposal 20) A measurement system, comprising:
   a second detection element configured to detect an electromagnetic signal from a power generator; and
   a detector,
   the detector being configured to output an output signal based on a control signal of a switching circuit configured to convert a power generated by the power generator and a second detection signal obtained from the second detection element.

According to the embodiment, a power generation system and a measurement system capable of stable operation can be provided.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in power generation systems such as power generators, power converters, detectors, detection elements, switching circuits, processing circuits, processors, etc., from known art. Such practice is included in the scope of the invention to the extent that similar effects thereto are obtained.

Further, any two or more components of the specific examples may be combined within the extent of technical feasibility and are included in the scope of the invention to the extent that the purport of the invention is included.

Moreover, all power generation systems and all measurement systems practicable by an appropriate design modification by one skilled in the art based on the power generation systems and the measurement systems described above as embodiments of the invention also are within the scope of the invention to the extent that the purport of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A power generation system (110-115, 113a-113c) comprising:
a power generator (20);
a power converter (10) configured to convert a power generated by the power generator (20);
a first detection element (31), a first distance between the first detection element and the power converter being shorter than a second distance between the first detection element and the power generator;
a second detection element (32); and
a detector (70) configured to output an output signal (Sx1) based on a signal information including a first detection signal (Sd1) obtained from the first detection element (31) and a second detection signal (Sd2) obtained from the second detection element (32).

2. The power generation system (110-115, 113a-113c) according to claim 1, wherein
the first detection signal (Sd1) includes a first electromagnetic signal from the power converter (10), and
the second detection signal (Sd2) includes a second electromagnetic signal from the power generator (20) and the first electromagnetic signal.

3. The power generation system (110-115, 113a-113c) according to claim 1 or 2, wherein
a third distance between the second detection element (32) and the power generator (20) is shorter than a fourth distance between the second detection element (32) and the power converter (10).

4. The power generation system (110-115, 113a-113c) according to any one of claims 1-3, wherein
the output signal (Sx1) includes information regarding a difference between a first signal based on the first detection signal (Sd1)and a second signal based on the second detection signal (Sd2).

5. The power generation system (110-115, 113a-113c) according to any one of claims 1-3, wherein
the detector (70) is configured to process a first signal (Sg1) based on the first detection signal (31) and a second signal (Sg2) based on the second detection signal (32) by a first process to derive the output signal (Sx1),
the first process includes at least one of a comparison process, a cancellation process, or a correlation process,
the comparison process includes deriving a result of comparing the first signal (Sg1) and the second signal (Sg2),
the cancellation process includes removing at least a part of a second signal component included in the second signal (Sg2) using at least a part of the first signal (Sg1), and
the correlation process includes deriving a component of at least one of the first signal (Sg1) and the second signal (Sg2), and a correlation value between the first signal (Sg1) and the second signal (Sg2) is less than a threshold value for the component.

6. The power generation system (110-115, 113a-113c) according to claim 1, wherein
the detector (70) includes a first circuit (71) and a processing circuit (75),
the first circuit (71) is configured to generate a first signal (Sg1) obtained by processing the first detection signal (Sd1) and a second signal (Sg2) obtained by processing the second detection signal (Sd2),
the processing circuit (75) is configured to generate the output signal (Sx1) according to a difference between the first signal (Sg1) and the second signal (Sg2).

7. The power generation system (112) according to claim 1, wherein
the detector includes a first circuit (71), a second circuit (72), and a processing circuit (75),
the first circuit (71) is configured to process the first detection signal (Sd1) to generate a first signal (Sg1),
the second circuit (72) is configured to process the second detection signal (Sd2) to generate a second signal (Sg2), and
the processing circuit (75) is configured to generate the output signal (Sx1) according to a difference between the first signal (Sg1) and the second signal (Sg2).

8. The power generation system (110-115, 113a-113c) according to any one of claims 1-7, wherein
the output signal (Sx1) corresponds to a first state of the power generator (20), and
the first state includes at least one of a failure of the power generator (20) or a deterioration of the power generator (20).

9. The power generation system (110-115, 113a-113c) according to claim 8, wherein
the detector (70) includes a processor (78), and
the processor (78) is configured to output information regarding the first state based on the output signal (Sx1).

10. The power generation system (110-115, 113a-113c) according to claim 8, wherein
the output signal includes information regarding the first state.

11. The power generation system (110-115, 113a-113c) according to any one of claims 1-10, wherein
the power converter (10) includes a switching circuit (11), and
the switching circuit (11) is configured to convert the power.

12. The power generation system (110-115, 113a-113c) according to any one of claims 1-11, wherein
the first detection element (31) includes a probe (31p), and
the probe (31p) is in contact with the power converter (20) or is not in contact with the power converter (20).

13. The power generation system (110-115, 113a-113c) according to any one of claims 1-12, wherein
the second detection element (32) includes an antenna (32a).

14. The power generation system (113) according to any one of claims 1-13, wherein
the power generator (20) includes a plurality of components (28),
the plurality of components (28) includes a first component (21),
the first component (21) is the closest to the power converter (10) among the plurality of components (28), and
a distance between the second detection element (32) and the first component (21) is shorter than a distance between the second detection element (32) and other of the plurality of components (28).

15. The power generation system (113a) according to any one of claims 1-13, wherein
the power generator (20) includes a plurality of components (28),
the plurality of components (28) includes a first component (21),
the first component (28) is located at a position including a center of the plurality of components (28), and
a distance between the second detection element (32) and the first component (21) is shorter than a distance between the second detection element (32) and other of the plurality of components (28).
